# FASCICULE DE BREVET EUROPEEN

(11) **EP 2 715 816 B1**
(45) Date de publication et mention de la délivrance du brevet: **26.12.2018**
(21) Numéro de dépôt: 12729022.9
(22) Date de dépôt: 29.05.2012
(51) Int. Cl.: H01L 35/30, H01L 35/32

(54) **MODULE ET DISPOSITIF THERMO ELECTRIQUES, NOTAMMENT DESTINES A GENERER UN COURANT ELECTRIQUE DANS UN VEHICULE AUTOMOBILE**
THERMOELEKTRISCHES MODUL UND VORRICHTUNG, INSBESONDERE ZUR ERZEUGUNG VON ELEKTRISCHEM STROM IN EINEM KRAFTFAHRZEUG
THERMOELECTRIC MODULE AND DEVICE, PARTICULARLY FOR GENERATING AN ELECTRIC CURRENT IN A MOTOR VEHICLE

(30) Priorité: 01.06.2011 FR 1154838
(43) Date de publication de la demande: 09.04.2014
(73) Titulaire: Valeo Systèmes Thermiques, 78321 Le Mesnil Saint Denis (FR); Simonin, Michel, 78960 Voisins le Bretonneux (FR)
(72) Inventeur: SIMONIN, Michel, F-78960 Voisins Le Bretonneux (FR)
(74) Mandataire: Gevers & Orès
(86) Numéro de dépôt international: PCT/EP2012/060052
(87) Numéro de publication internationale: WO 2012/163916

(56) Documents cités:
- EP-A1- 1 780 807
- US-A- 4 095 998
- US-A1- 2008 028 769

## Description

La présente invention concerne un module et un dispositif thermo électriques, notamment destinés à générer un courant électrique dans un véhicule automobile.

Dans le domaine automobile, il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Des tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

Les éléments thermo électriques connus sont de forme parallélépipédique rectangle et le gradient de température permettant de générer le courant électrique attendu est imposé entre deux de leurs faces opposées. Il s'agit donc de faces de même dimension.

Or, les coefficients d'échanges thermiques par convection entre un fluide et la paroi d'un tube dans le cas respectivement d'un liquide et d'un gaz sont très différents. L'efficacité thermique de l'ensemble est ainsi limitée par le fluide, ici les gaz d'échappement, présentant le plus faible coefficient d'échange thermique.

Une première solution pour résoudre ce problème est d'augmenter les surfaces d'échanges côtés gaz. Mais une telle solution présente des limites car, comme les dispositifs sont installés sur la voie d'échappement du véhicule, ils doivent impérativement présenter une résistance à l'écoulement des gaz aussi faible que possible pour limiter l'effet de contre-pression due, soit à la définition des surfaces d'échange placées dans le tube, soit à l'effet d'encrassement par dépôt des suies contenues dans les gaz, qui seraient préjudiciables au bon fonctionnement non seulement du dispositif thermo électrique mais aussi du moteur. Ces contraintes limitent donc la possibilité d'augmenter fortement le coefficient d'échange par des surfaces d'échanges à haut rendement.

Les coefficients d'échange côté gaz sont ainsi inférieurs aux coefficients d'échange côté liquide d'une valeur pouvant dépasser dix. Les surfaces d'échange étant identiques, le rapport entre la résistance thermique côté gaz et la résistance thermique côté liquide se trouve être l'inverse du rapport entre le coefficient d'échange thermique côté gaz et le coefficient d'échange côté liquide. La résistance thermique côté gaz est ainsi très supérieure à la résistance thermique côté liquide, ce qui pénalise le rendement du dispositif.

L'invention se propose d'améliorer la situation et concerne à cet effet un module thermo électrique comprenant au moins un élément thermo électrique, susceptible de générer un courant électrique sous l'action d'un gradient de température exercé entre deux de ses faces, l'une, dite première, desdites faces étant de surface supérieure à l'autre, dite seconde, ledit module étant configuré pour établir un échange thermique entre ladite première face et un premier fluide et pour établir un échange thermique entre ladite seconde face et un second fluide, ledit second fluide présentant un coefficient d'échange thermique supérieur audit premier fluide.

En utilisant une surface d'échange plus grande au niveau du fluide présentant le coefficient d'échange le plus faible, il est ainsi possible de disposer d'un rapport entre la résistance thermique côté gaz et la résistance thermique côté liquide plus équilibré, favorisant le fonctionnement de l'ensemble. Ceci est connu du document US4095998.

Afin d'améliorer encore le fonctionnement de l'ensemble, le module se caractérise à titre principal en ce qu'il comprend une pluralité de dits éléments thermo électriques et en ce qu'il comprend un canal de circulation de liquide froid au contact de ladite seconde surface desdits éléments thermo électriques et un canal de circulation de gaz au contact de ladite première surface desdits éléments thermo électriques, le canal de circulation de gaz étant muni de surfaces d'échange secondaire, le module comprenant une enveloppe externe isolante, notamment une enveloppe permettant une isolation thermique entre des gaz d'échappement et l'air ambiant, ladite enveloppe externe définissant une paroi externe du canal de circulation de gaz.

Selon différents aspects de l'invention, qui pourront être pris ensemble ou séparément :
- l'élément thermo électrique est en forme d'anneau ou de portion d'anneau, la première surface est définie par une surface de périphérie extérieure de l'anneau et la seconde surface est définie par une surface de périphérie intérieure de l'anneau,
- lesdites première et/ou seconde surfaces sont générées par une droite,
- lesdites première et/ou seconde surfaces sont de forme cylindrique,
- la première surface présente un rayon compris entre 1,5 et 4 fois le rayon de la seconde surface,
- lesdites première et/ou seconde surfaces sont coaxiales,
- ledit élément thermo électrique présente deux faces planes parallèles opposées,
- lesdits éléments thermo électriques sont de deux types, un premier type, dit P, permettant d'établir une différence de potentiel électrique entre lesdites première et deuxième faces, lorsqu'ils sont soumis à un gradient de température donné, et d'un second type, dit N, permettant la création d'une différence de potentiel électrique dans un sens opposé entre lesdites première et deuxième faces, lorsqu'ils sont soumis au même gradient de température,
- lesdits éléments thermo électriques sont disposés dans le prolongement longitudinal l'un de l'autre et les éléments thermo électriques de type P alternent avec les éléments thermo électriques de type N,
- les éléments thermo électriques sont groupés par paires, formées d'un dit élément thermo électrique de type P et d'un dit élément thermo électrique de type N, ledit module étant configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine,
- lesdits éléments thermo électriques sont disposés les uns par rapport aux autres de façon à ce que leur première et/ou seconde surface soient dans le prolongement l'une de l'autre,
- lesdits éléments thermo électriques sont de forme et de dimension identiques,
- lesdites première et/ou seconde surfaces sont inscrites dans une surface générée par une droite,
- le ou lesdits canaux de circulation de liquide froid sont circulaire et le canal de circulation de gaz est annulaire, lesdits éléments thermo électriques étant disposés radialement entre le ou lesdits canaux de circulation de liquide froid, d'une part, et le canal de circulation de gaz, d'autre part.

Selon un mode de mise en oeuvre, le module comprend une pluralité de tubes positionnés dans le prolongement axial les uns des autres de manière à définir ledit canal de circulation de fluide froid et/ou une pluralité de tubes positionnés dans le prolongement axial les uns des autres de manière à définir des portions successives d'une paroi intérieure dudit canal de circulation de gaz.

Selon ce mode de réalisation, le dispositif pourra présenter les caractéristiques suivantes :
- des joints d'étanchéité sont prévus entre lesdits tubes de circulation du liquide froid successifs et/ou entre lesdits tubes de circulation de gaz successifs, assurant en outre une isolation électrique, respectivement, entre lesdits tubes de circulation du liquide froid et/ou entre lesdits tubes de circulation de gaz,
- les tubes de circulation de liquide froid et/ou de circulation de gaz sont munis d'épaulements contre lesquels les éléments thermo électriques et/ou les joints d'étanchéité sont en appui.

Selon une autre variante de réalisation, le module comprend un tube de circulation de liquide froid sur lequel sont montés au moins deux éléments thermo électriques du même type alternant selon la direction d'extension longitudinale avec un élément thermo électrique de l'autre type.

Selon ce mode de réalisation, le dispositif pourra présenter les caractéristiques suivantes :
- les éléments thermo électriques sont revêtus d'une couche de matériau isolante électriquement et conductrice thermiquement définissant au moins en partie une paroi intérieure du canal de circulation de gaz,
- la surface d'échange secondaire est configurée pour assurer le maintien des éléments thermo électriques.

Selon l'invention, le module pourra également comprendre une pluralité de canaux de circulation de liquide froid, notamment parallèles entre eux, chaque canal coopérant avec une pluralité d'éléments thermo électriques formant chacun une section angulaire de cylindre et positionnés les uns dans le prolongement des autres selon la direction d'extension longitudinale du canal correspondant.

L'invention concerne également un dispositif thermo électrique comprenant une pluralité de modules tels que décrit plus haut.

Selon différents aspects de l'invention pris ensemble ou séparément :
- ledit dispositif comprend un corps présentant une pluralité de logements accueillant lesdits modules,
- ledit corps est en matériau réfractaire, isolant et/ou alvéolaire,
- lesdits modules sont maintenus dans lesdits logements par les surfaces d'échange secondaires,
- lesdits logements sont disposés de façon à ce que les canaux de circulation du gaz des différents modules soient parallèles les uns aux autres,
- le dispositif comprend un canal de circulation de gaz by-passant lesdits modules,
- ledit corps est revêtu d'une enveloppe externe anti-choc.

L'invention sera mieux comprise à la lumière de la description suivante qui n'est donnée qu'à titre indicatif et qui n'a pas pour but de la limiter, accompagnée des dessins joints parmi lesquels :
- la figure 1 illustre de façon schématique, selon un plan de coupe axiale, un premier exemple de module conforme à l'invention,
- la figure 2 est une vue de coupe selon la ligne II-II de la figure 1, illustrant une portion dudit premier exemple de module conforme à l'invention,
- les figures 3a à 3e illustrent de façon schématique, en perspective, les différentes étapes de montage d'un deuxième exemple de module conforme à l'invention,
- la figure 4 illustre de façon schématique, selon un plan de coupe diamétrale, un autre exemple de réalisation d'un module conforme à l'invention,
- la figure 5 illustre de façon schématique en perspective le corps d'un exemple de dispositif conforme à l'invention,
- la figure 6 illustre un exemple de dispositif conforme à l'invention muni du corps de la figure 5,
- la figure 7 illustre de façon schématique, selon un plan de coupe diamétrale, une variante de réalisation du dispositif conforme à l'invention.

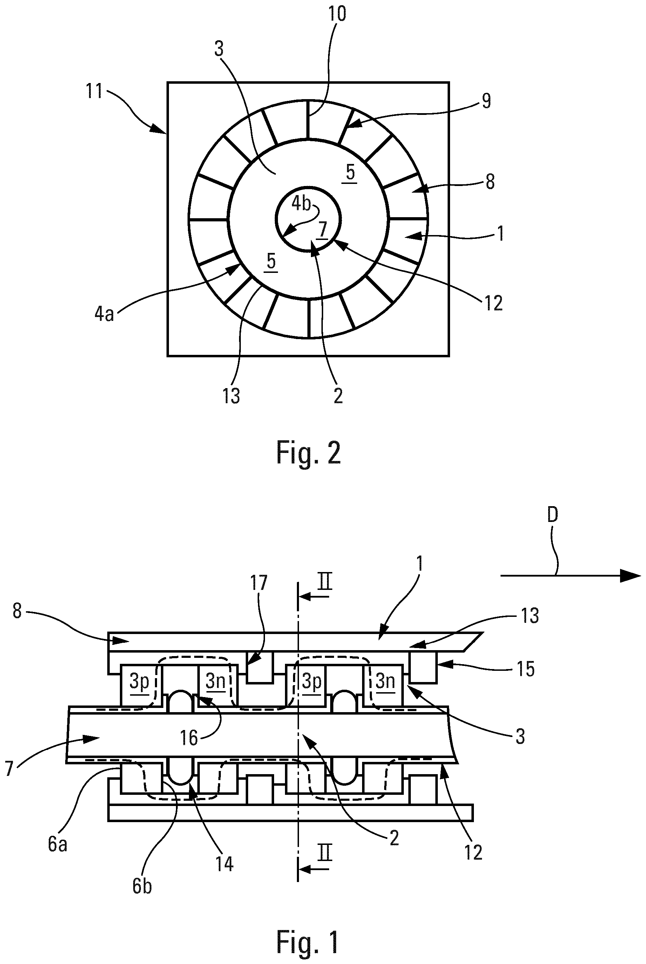

Comme illustré aux figures 1 à 4, l'invention concerne un module thermo électrique, comprenant un premier circuit 1, dit chaud, apte à permettre la circulation d'un premier fluide, notamment des gaz d'échappement d'un moteur, et un second circuit 2, dit froid, apte à permettre la circulation d'un second fluide, notamment un fluide caloporteur d'un circuit de refroidissement, de température inférieure à celle du premier fluide.

Le module comprend également une pluralité d'élément thermo électrique 3, 3p, 3n, susceptibles de générer un courant électrique sous l'action d'un gradient de température exercé entre deux de leurs faces 4a, 4b. De tels éléments fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques sont, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

Selon l'invention, l'une 4a, dite première, desdites faces est de surface supérieure à l'autre 4b, dite seconde, et ledit module est configuré pour établir un échange thermique entre ladite première face et le premier fluide et pour établir un échange thermique entre ladite seconde face et le second fluide, ledit second fluide présentant un coefficient d'échange thermique supérieure audit premier fluide.

On favorise ainsi l'échange entre les éléments thermo électriques 3p, 3n, et le fluide présentant le coefficient d'échange thermique le plus faible, ici, les gaz d'échappement.

On décrit dans la suite un exemple d'élément thermo électrique équipant le module conforme à l'invention.

Ses dites première 4a et/ou seconde 4b surfaces sont, par exemple, générées par une droite. Cela facilitera la configuration des circuits de fluide 1, 2. Elles sont ainsi, notamment, de forme cylindrique.

On pourra de la sorte utiliser un élément thermo électrique en forme d'anneau ou de portion d'anneau, la première surface 4a étant définie par une surface de périphérie extérieure de l'anneau tandis que la seconde surface 4b est définie par une surface de périphérie intérieure de l'anneau.

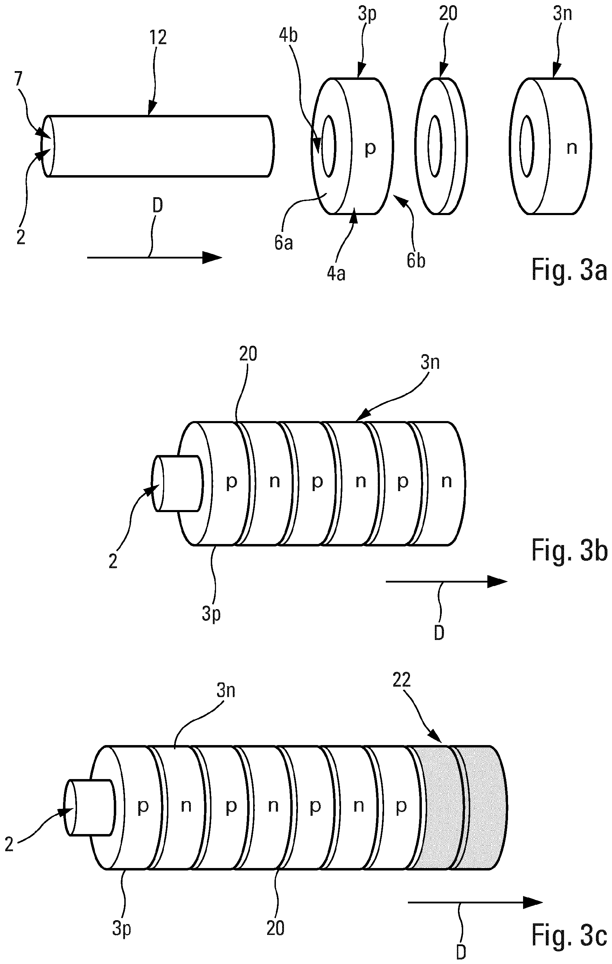

A la figure 2, l'élément thermo électrique 3 représenté est constitué d'un anneau formé de deux demi-anneaux 5 identiques et disposés symétriquement l'un par rapport à l'autre. Aux figures 3a à 3f, il s'agit d'anneaux en une seule pièce.

La première surface 4a présente, par exemple, un rayon compris entre 1,5 et 4 fois le rayon de la seconde surface 4b. Il pourra s'agir d'un rayon égal à environ 2 fois celui de la seconde surface 4b.

Pour faciliter l'homogénéité de l'échange thermique angulairement le long de l'élément thermo électrique, lesdites première et/ou seconde surfaces 4a, 4b sont, par exemple coaxiales. Autrement dit, l'élément thermo électrique est muni d'une épaisseur radiale constante.

Ledit élément thermo électrique présente, par exemple, deux faces planes 6a, 6b parallèles opposées. Autrement dit, l'anneau constituant l'élément thermo électrique est de section annulaire rectangulaire.

On décrit dans la suite l'association des éléments thermo électriques entre eux dans le module conforme à l'invention.

Lesdits éléments thermo électriques 3p, 3n sont disposés, par exemple, dans le prolongement longitudinal l'un de l'autre, notamment de façon coaxiale, et les éléments thermo électriques de type P alternent avec les éléments thermo électriques de type N, selon une direction D. Ils sont, notamment, de forme et de dimension identiques.

Lesdits éléments thermo électriques 3p, 3n sont, par exemple, groupés par paire, chaque paire étant formée d'un dit élément thermo électrique de type P et d'un dit élément thermo électrique de type N, et ledit module est configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine. Ceci est particulièrement illustré dans le mode de réalisation de la figure 1 où la circulation du courant électrique est symbolisée par des traits en pointillés. On assure de la sorte une circulation en série du courant électrique entre les éléments thermo électriques 3p, 3n disposés les uns à côtés des autres selon la direction D.

A nouveau pour faciliter la configuration des circuits de circulation de fluide 1, 2, on pourra prévoir que lesdits éléments thermo électriques 3p, 3n soient disposés les uns par rapport aux autres de façon à ce que leur première et/ou seconde surface 4a, 4b soient dans le prolongement l'une de l'autre. Lesdites première et/ou seconde surfaces 4a, 4b sont ainsi inscrites, par exemple, dans une surface générée par une droite.

Pour la circulation des fluides, le module conforme à l'invention comprend un canal 7 de circulation de liquide froid au contact de ladite seconde surface 4b desdits éléments thermo électriques 3p, 3n et un canal 8 de circulation de gaz au contact de ladite première surface 4a desdits éléments thermo électriques 3p, 3n.

Le ou lesdits canaux 7 de circulation de liquide de section sont, par exemple, de section circulaire. Ledit canal 8 de circulation de gaz est, par exemple de section annulaire. Lesdits éléments thermo électriques 3p, 3n sont, disposés entre lesdits canaux 7, 8, par exemple, radialement.

Selon les modes de réalisation des figures 1 et 2, d'une part, et 3a à 3e, d'autre part, ledit canal 7 de circulation de liquide froid et ledit canal 8 de circulation de gaz sont coaxiaux.

Pour améliorer encore l'échange thermique entre les éléments thermo électriques 3p, 3n et le second fluide, le canal 8 de circulation de gaz pourra être muni de surfaces d'échange secondaire 9. Il s'agit, par exemple, d'ailettes radiales 10. Comme détaillé plus loin, lesdites surfaces d'échange secondaire pourront également avoir d'autres fonctions, notamment de montage.

Afin de le protéger et de l'isoler de l'extérieur, le module conforme à l'invention pourra comprendre une enveloppe externe isolante 11, définissant éventuellement une paroi externe du canal 8 de circulation de gaz.

Selon le mode de réalisation des figures 1 et 2, le module conforme à l'invention comprend une pluralité de tubes 12, positionnés dans le prolongement axial les uns des autres de manière à définir ledit canal 7 de circulation de fluide froid. Il comprend également une pluralité de tubes 13, positionnés dans le prolongement axial les uns des autres de manière à définir des portions successives d'une paroi intérieure dudit canal 8 de circulation de gaz.

Les tubes 13 de circulation de gaz sont, par exemple, coaxiaux par rapport aux tubes 12 de circulation de liquide froid qui sont placés à l'intérieur desdits tubes 13 de circulation de gaz en étant axialement décalés par rapport à ceux-ci. Plus précisément, un tube 12 de circulation de liquide froid est ici centré, selon la direction D, entre deux tubes 13 de circulation de gaz.

A chaque tube 12 du canal 7 de circulation de liquide froid, il est associé une paire d'éléments thermo électriques 3p, 3n. Aux tubes 13 de circulation de gaz voisins, c'est-à-dire, aux tubes 13 à l'intérieur desquels ledit tube 12 de circulation de liquide froid est placé, l'un desdits éléments thermo électriques 3p, 3n dudit tube 12 est associé ainsi qu'un élément 3n, respectivement 3p de la paire d'éléments thermo électriques 3p, 3n voisine.

Des joints d'étanchéité 14, 15 pourront aussi être prévus entre lesdits tubes 12 de circulation du liquide froid successifs et/ou entre lesdits tubes 13 de circulation de gaz successifs. Outre leur rôle d'étanchéité, ils assurent une isolation électrique, respectivement, entre lesdits tubes 12 de circulation du liquide froid et/ou entre lesdits tubes 13 de circulation de gaz.

Lesdits tubes 12, 13 sont, par exemple, métalliques. Ils sont revêtus, par exemple, d'une fine couche de matériau, par exemple céramique, assurant une conduction thermique et une isolation électrique entre les tubes et les éléments thermo électriques. Pour la conduction électrique entre les éléments thermo électriques 3p, 3n, ladite couche de matériau pourra être revêtue de pistes électriques.

Dans ce mode de réalisation, les ailettes 10 sont, par exemple, issues de matière des tubes 13 de circulation de gaz qui sont obtenus, par exemple, par extrusion.

Dans ce module, les tubes 12, 13 de circulation de liquide froid et/ou de circulation de gaz pourront être munis d'épaulements 16, 17 contre lesquels les éléments thermo électriques 3p, 3n et/ou les joints d'étanchéité 14, 15 sont en appui. Lesdits épaulements sont prévus, par exemple, à l'extrémité longitudinale desdites tubes 12, 13.

Les éléments thermo électriques 3p, 3n sont en appui, sur l'une de leur face plane 6a, contre les épaulements 17 des tubes 13 de circulation de gaz au niveau de leur périphérie externe et, sur leur face plane opposée 6b, contre les épaulements 16 de tube de circulation de liquide froid au niveau de leur périphérie interne. Les joints 14, 15 sont placés entre deux épaulements de tubes 12, 13 respectifs.

A titre d'exemple, le montage du module est réalisé par expansion radiale des tubes 12 de circulation du liquide froid de manière à plaquer lesdits éléments thermo électriques 3p, 3n sur les tubes 13 de circulation de gaz. En variante, il est obtenu par serrage des tubes de circulation de gaz 13 de manière à plaquer les éléments thermo électriques 3p, 3n sur les tubes 12 de circulation de liquide froid. Un matériau assurant un meilleur contact entre les éléments thermo électriques 3p, 3n et les tubes pourra aussi être employé.

Selon le mode de réalisation des figures 3a à 3e, le module conforme à l'invention comprend un tube 12 de circulation de liquide froid sur lequel sont montés au moins deux éléments thermo électriques du même type alternant selon la direction d'extension longitudinale D du tube avec un élément thermo électrique de l'autre type. En l'occurrence, comme cela ressort des figures 3b à 3e, une pluralité d'éléments thermo électriques 3p alterne avec une pluralité d'éléments thermo électriques 3n.

Si l'on se rapporte à la figure 3a, on constate qu'une rondelle 20, électriquement isolante, pourra être disposée entre deux faces 6a, 6b en vis-à-vis d'éléments thermo électriques voisins 3p, 3n selon la direction d'extension D longitudinale du tube 12. A la figure 3b, les éléments thermo électriques 3p, 3, et les rondelles 20 sont assemblés, de façon alternée, sur le tube 12 de circulation de fluide froid.

Comme illustré à la figure 3c, les éléments thermo électriques 3p, 3n sont, par exemple, revêtus deux à deux d'une couche 22 de matière électriquement conductrice, notamment en cuivre et/ou en nickel.

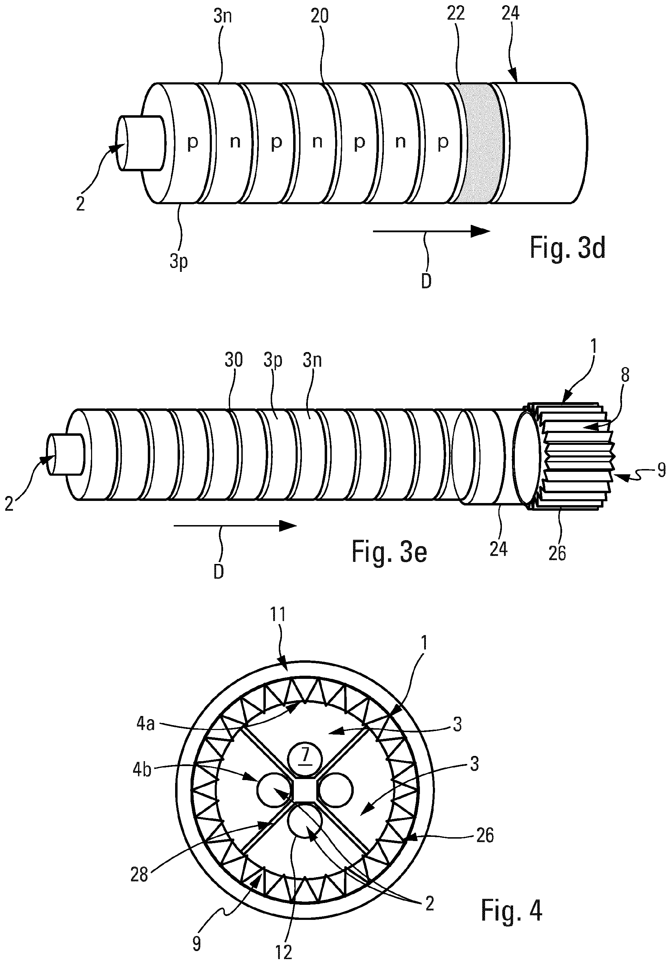

Comme illustré à la figure 3d, les éléments thermo électriques 3p, 3n sont aussi revêtus, par exemple, d'une couche 24 de matériau, isolante électriquement et conductrice thermiquement, définissant au moins en partie une paroi intérieure du canal 8 de circulation de gaz. Il s'agit, notamment, d'un matériau céramique. Ladite couche 24 de matière isolante électriquement et conductrice thermiquement est située au dessus de la couche 22 de matière électriquement conductrice

Le tube froid 12 est, notamment, métallique. Comme dans le précédent mode de réalisation, il est revêtu, par exemple, d'une fine couche de matériau, par exemple céramique, assurant une conduction thermique et une isolation électrique entre le tube et les éléments thermo électriques 3p, 3n. Pour la conduction électrique entre les éléments thermo électriques 3p, 3n, ladite couche de matériau pourra être revêtue de pistes électriques, notamment dans le but d'assurer une connexion en série des éléments thermo électriques le long de la direction D.

Comme illustré à la figure 3e, la surface d'échange secondaire 9 de ce type de module est configurée pour assurer le maintien des éléments thermo électriques 3p, 3n. Il s'agit, par exemple, d'un turbulateur 26, métallique, présentant une élasticité radiale et propre à subir une précompression.

Bien que cela ne soit pas représenté en relation avec le mode de réalisation des figures 3a à 3e, la périphérie extérieure du canal 8 de circulation de gaz est entourée d'une enveloppe de matériau protectrice, réfractaire et/ou isolante. Ladite enveloppe pourra former une surface d'appui pour le turbulateur 26.

Selon ce qui précède, le canal 7 de circulation de liquide froid est unique et placé au centre du module.

Selon une variante, illustré à la figure 4, le module comprenant une pluralité de canaux 7 de circulation de liquide froid, parallèle entre eux, chaque canal coopérant avec une pluralité d'éléments thermo électriques 3 formant chacun une section angulaire de cylindre et positionnés les uns dans le prolongement des autres selon la direction d'extension longitudinale du canal correspondant.

Chaque canal 7 est défini, par exemple, par un tube 12 de circulation de liquide froid. Les tubes de circulation 12 de liquide froid sont au nombre de n, ici 4, et les éléments thermo électriques 3 sont de même section angulaire d'un tube à l'autre, sensiblement de (360/n) degrés d'angle, ici des quadrants cylindriques de 90°, pour définir un cylindre de section ronde. Les tubes de circulation 12 de liquide froid sont, par exemple, parallèles entre eux. Ils forment ici quatre arrêtes d'un parallélogramme rectangle.

Les éléments thermo électriques 3 sont, par exemple, de même épaisseur et empilés par tranches successives, une tranche comprenant un élément thermo électrique 3 associé à chacun des tubes 12 de circulation de liquide froid.

Des croisillons 28 pourront être prévus entre chaque quadrant ou portion équivalente pour séparer et maintenir les éléments thermo électriques 3.

Pour le reste, le module pourra être conforme à celui des figures 3a à 3e. Il pourra ainsi comprendre une enveloppe protectrice 11.

Selon un premier exemple de réalisation, le module des différents exemples de réalisation précédents est destiné à être utilisé de façon individuelle.

Comme illustré dans la suite, ils pourront aussi former un crayon, destiné à venir s'insérer dans un logement d'accueil d'un corps d'un dispositif thermo électrique.

Plus largement, l'invention concerne encore d'ailleurs un dispositif comprenant une pluralité de modules tels que décrit plus haut.

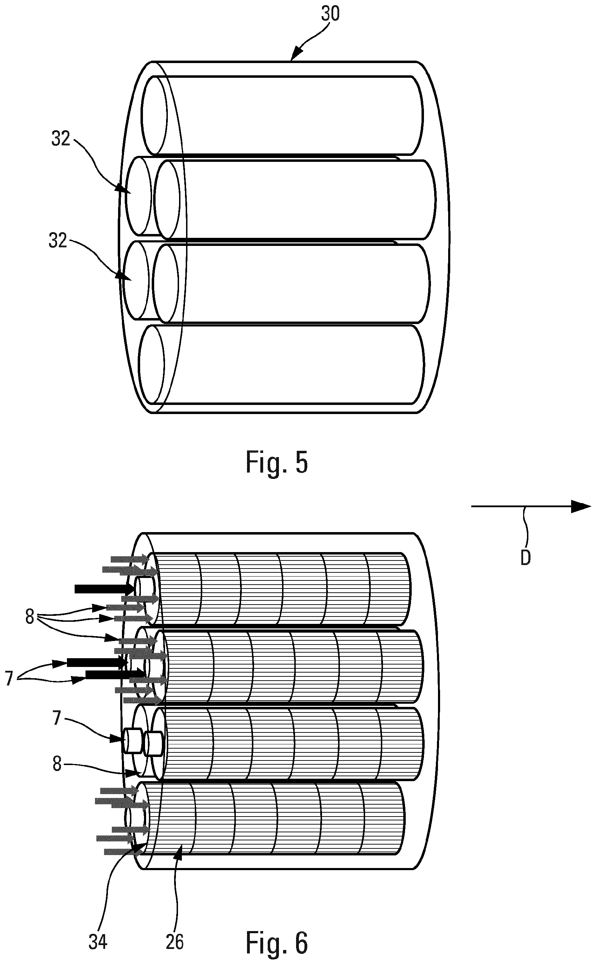

Comme illustré à la figure 5, ledit module pourra comprendre un corps 30 présentant une pluralité de logements 32 accueillant lesdits modules 34.

Ledit corps est, par exemple, en matériau réfractaire, isolant et/ou alvéolaire.

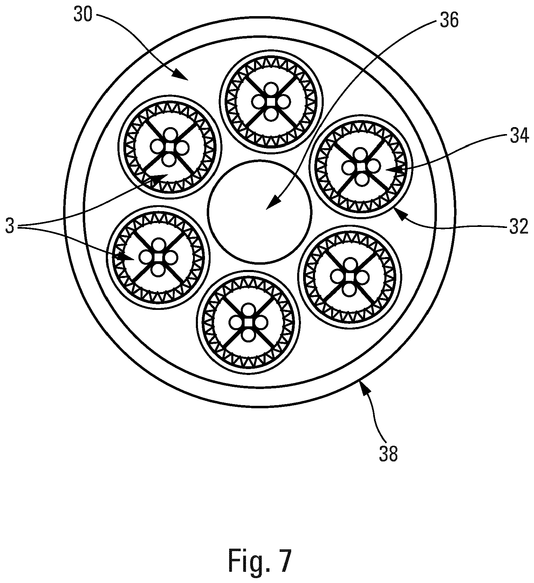

Comme illustré aux figures 6 et 7, dans le cas des modules crayon évoqués plus haut, ces derniers pourront être insérés dans lesdits logements 32 et maintenus dans ceux-ci, notamment centrés, à l'aide des turbulateurs 26. La paroi externe du canal 8 de circulation de gaz pourra alors être définie directement par ledit corps 30. Ainsi, lesdits modules 34 sont maintenus dans lesdits logements 32 par les surfaces d'échange secondaires 9, notamment grâce à leur élasticité radiale.

Lesdits logements 32 sont disposés, notamment, de façon à ce que les canaux de circulation du gaz des différents modules soient parallèles les uns aux autres.

Ledit corps 30 présente, notamment, une configuration sensiblement cylindriques et les logements 32 sont parallèles entre eux et parallèles à l'axe du corps 30. Ils sont, par exemple, régulièrement espacés à sa périphérie.

D'un point de vue électrique, les modules pourront être connectés entre eux en série et/ou en parallèle, par des connexions, non représentées, situées à leurs extrémités longitudinales.

En variante, comme illustré à la figure 7, le dispositif pourra comprendre un canal 36 de circulation de gaz by-passant lesdits modules 34. Il est prévu, notamment au centre dans le corps 30.

Ledit corps pourra encore être revêtu d'une enveloppe externe 38 anti-choc.

## Revendications

1. Module thermo électrique comprenant au moins un élément thermo électrique (3, 3p, 3n), susceptible de générer un courant électrique sous l'action d'un gradient de température exercé entre deux de ses faces, l'une (4a), dite première, desdites faces étant de surface supérieure à l'autre (4b), dite seconde, ledit module étant configuré pour établir un échange thermique entre ladite première face (4a) et un premier fluide et pour établir un échange thermique entre ladite seconde face (4b) et un second fluide, ledit second fluide présentant un coefficient d'échange thermique supérieur audit premier fluide, ledit module étant **caractérisé en ce qu'**il comprend une pluralité de dits éléments thermo électriques (3, 3p, 3n), et **en ce qu'**il comprend également un canal (7) de circulation de liquide froid au contact de ladite seconde surface (4b) desdits éléments thermo électriques (3, 3p, 3n) et un canal (8) de circulation de gaz au contact de ladite première surface (4a) desdits éléments thermo électriques (3, 3p, 3n), le canal (8) de circulation de gaz étant muni de surfaces d'échange secondaire (9), ledit module comprenant une enveloppe externe isolante (11) définissant une paroi externe du canal (8) de circulation de gaz.

2. Module selon la revendication 1 dans lequel l'élément thermo électrique (3, 3p, 3n) est en forme d'anneau ou de portion d'anneau, la première surface (4a) est définie par une surface de périphérie extérieure de l'anneau, la seconde surface (4b) est définie par une surface de périphérie intérieure de l'anneau.

3. Module selon l'une quelconque des revendications précédentes dans lequel lesdites première et/ou seconde surfaces (4a, 4b) sont de forme cylindrique.

4. Module selon la revendication 3 dans lequel la première surface (4a) présente un rayon compris entre 1,5 et 4 fois le rayon de la seconde surface (4b).

5. Module selon l'une quelconque des revendications précédentes dans lequel ledit élément thermo électrique (3, 3p, 3n) présente deux faces planes parallèles opposées (6a, 6b).

6. Module selon l'une quelconque des revendications précédentes comprenant une pluralité de tubes (12) positionnés dans le prolongement axial les uns des autres de manière à définir ledit canal (7) de circulation de fluide froid et/ou une pluralité de tubes (13) positionnés dans le prolongement axial les uns des autres de manière à définir des portions successives d'une paroi intérieure dudit canal (8) de circulation de gaz.

7. Module selon la revendication 6 dans lequel des joints d'étanchéité (14,15) sont prévus entre lesdits tubes (12) de circulation du liquide froid successifs et/ou entre lesdits tubes (13) de circulation de gaz successifs, assurant une isolation électrique, respectivement, entre lesdits tubes de circulation du liquide froid (12) et/ou entre lesdits tubes de circulation de gaz (13).

8. Module selon la revendication 7 dans lequel les tubes (12, 13) de circulation de liquide froid et/ou de circulation de gaz sont munis d'épaulements (16, 17) contre lesquels les éléments thermo électriques et/ou les joints d'étanchéité (14, 15) sont en appui.

9. Module selon l'une quelconque des revendications précédentes comprenant un tube (12) de circulation de liquide froid sur lequel sont montés au moins deux éléments thermo électriques (3, 3p, 3n) du même type alternant selon la direction d'extension longitudinale avec un élément thermo électrique de l'autre type.

10. Module selon la revendication 8 dans lequel les éléments thermo électriques (3, 3p, 3n) sont revêtus d'une couche de matériau isolante électriquement et conductrice thermiquement définissant au moins en partie une paroi intérieure du canal (8) de circulation de gaz.

11. Module selon l'une quelconque des revendications 9 ou 10 comprenant une surface d'échange secondaire (9), prévue dans le canal (8) de circulation de gaz et configurée pour assurer le maintien des éléments thermo électriques (3, 3p, 3n).

12. Module selon l'une quelconque des revendications précédentes comprenant une pluralité de canaux (12) de circulation de liquide froid, parallèle entre eux, chaque canal (12) coopérant avec une pluralité d'éléments thermo électriques (3, 3p, 3n) formant chacun une section angulaire de cylindre et positionnés les uns dans le prolongement des autres selon la direction d'extension longitudinale du canal (12) correspondant.

13. Dispositif thermo électrique comprenant une pluralité de modules selon l'une quelconque des revendications précédentes.

14. Dispositif selon la revendication 13 comprenant un corps (30) présentant une pluralité de logements (32) accueillant lesdits modules (34).

15. Dispositif selon la revendication 14 dans lequel lesdits modules (34) sont maintenus dans lesdits logements (32) par des surfaces d'échange secondaires (9).

16. Dispositif selon l'une quelconque des revendications 14 ou 15 dans lequel lesdits logements (32) sont disposés de façon à ce que les canaux (7, 8) de circulation du gaz des différents modules (34) soient parallèles les uns aux autres.

17. Dispositif selon l'une quelconque des revendications 14 à 16 dans lequel ledit corps (30) est revêtu d'une enveloppe externe anti-choc (38).

18. Dispositif selon l'une quelconque des revendications 13 à 17 comprenant un canal (36) de circulation de gaz by-passant lesdits modules (34).

## Patentansprüche

1. Thermoelektrisches Modul, umfassend mindestens ein thermoelektrisches Element (3, 3p, 3n), das in der Lage ist, einen elektrischen Strom unter der Wirkung eines Temperaturgradienten zu erzeugen, der zwischen zwei seiner Flächen ausgeübt wird, wobei die eine (4a), genannt erste, der Flächen eine größere Oberfläche als die andere (4b), genannt zweite, aufweist, wobei das Modul konfiguriert ist, um einen Wärmeaustausch zwischen der ersten Fläche (4a) und einem ersten Fluid herzustellen und einen Wärmeaustausch zwischen der zweiten Fläche (4b) und einem zweiten Fluid herzustellen, wobei das zweite Fluid einen Wärmeaustauschkoeffizienten aufweist, der größer als das erste Fluid ist, wobei das Modul **dadurch gekennzeichnet ist, dass** es eine Vielzahl der thermoelektrischen Elemente (3, 3p, 3n) umfasst, und dass es auch einen Kanal (7) zur Zirkulation von kalter Flüssigkeit in Kontakt mit der zweiten Oberfläche (4b) der thermoelektrischen Elemente (3, 3p,3n) und einen Kanal (8) zur Zirkulation von Gas in Kontakt mit der ersten Oberfläche (4a) der thermoelektrischen Elemente (3, 3p, 3n) umfasst, wobei der Kanal (8) zur Zirkulation von Gas mit sekundären Austauschflächen (9) versehen ist, wobei das Modul eine isolierende Außenhülle (11) umfasst, die eine Außenwand des Kanals (8) zur Zirkulation von Gas definiert.

2. Modul nach Anspruch 1, wobei das thermoelektrische Element (3, 3p, 3n) die Form eines Rings oder Ringabschnitts aufweist, die erste Oberfläche (4a) durch eine äußere Umfangsfläche des Rings definiert ist, die zweite Oberfläche (4b) durch eine innere Umfangsfläche des Rings definiert ist.

3. Modul nach einem der vorstehenden Ansprüche, wobei die erste und/oder zweite Oberfläche (4a, 4b) eine zylindrische Form aufweist.

4. Modul nach Anspruch 3, wobei die erste Oberfläche (4a) einen Radius zwischen dem 1,5- und 4-fachen des Radius der zweiten Oberfläche (4b) aufweist.

5. Modul nach einem der vorstehenden Ansprüche, wobei das thermoelektrische Element (3, 3p, 3n) zwei gegenüberliegende parallele planare Flächen (6a, 6b) aufweist.

6. Modul nach einem der vorstehenden Ansprüche, umfassend eine Vielzahl von Rohren (12), die in der axialen Verlängerung voneinander derart angeordnet sind, dass sie den Kanal (7) zur Zirkulation von kaltem Fluid definieren und/oder eine Vielzahl von Rohren (13), die in der axialen Verlängerung voneinander derart angeordnet sind, dass sie aufeinanderfolgende Abschnitte einer Innenwand des Kanals (8) zur Zirkulation von Gas definieren.

7. Modul nach Anspruch 6, wobei Dichtungen (14, 15) zwischen den aufeinanderfolgenden Rohren (12) zur Zirkulation der kalten Flüssigkeit und/oder zwischen den aufeinanderfolgenden Rohren (13) zur Zirkulation von Gas vorgesehen sind, die jeweils eine elektrische Isolierung zwischen den Rohren (12) zur Zirkulation der kalten Flüssigkeit und/oder zwischen den Rohren (13) zur Zirkulation von Gas gewährleisten.

8. Modul nach Anspruch 7, wobei die Rohre (12, 13) zur Zirkulation von kalter Flüssigkeit und/oder zur Zirkulation von Gas mit Schultern (16, 17) versehen sind, gegen die die thermoelektrischen Elemente und/oder die Dichtungen (14, 15) abgestützt sind.

9. Modul nach einem der vorstehenden Ansprüche, umfassend ein Rohr (12) zur Zirkulation von kalter Flüssigkeit, auf dem mindestens zwei thermoelektrische Elemente (3, 3p, 3n) des gleichen Typs angebracht sind, die sich in Richtung der Längserstreckung mit einem thermoelektrischen Element des anderen Typs abwechseln.

10. Modul nach Anspruch 8, wobei die thermoelektrischen Elemente (3, 3p, 3n) mit einer Schicht aus elektrisch isolierendem und wärmeleitendem Material überzogen sind, die zumindest teilweise eine Innenwand des Kanals (8) zur Zirkulation von Gas definiert.

11. Modul nach einem der Ansprüche 9 oder 10, umfassend eine sekundäre Austauschfläche (9), die im Kanal (8) zur Zirkulation von Gas vorgesehen ist und konfiguriert ist, um die Aufrechterhaltung der thermoelektrischen Elemente (3, 3p, 3n) zu gewährleisten.

12. Modul nach einem der vorstehenden Ansprüche, umfassend eine Vielzahl von Kanälen (12) zur Zirkulation von kalter Flüssigkeit, parallel zueinander, wobei jeder Kanal (12) mit einer Vielzahl von thermoelektrischen Elementen (3, 3p, 3n) zusammenwirkt, die jeweils einen Zylinderwinkelabschnitt bilden und in der Verlängerung voneinander in Richtung der Längserstreckung des entsprechenden Kanals (12) angeordnet sind.

13. Thermoelektrische Vorrichtung, umfassend eine Vielzahl von Modulen nach einem der vorstehenden Ansprüche.

14. Vorrichtung nach Anspruch 13, umfassend einen Körper (30), der eine Vielzahl von Aufnahmen (32) zur Aufnahme der Module (34) aufweist.

15. Vorrichtung nach Anspruch 14, wobei die Module (34) in den Aufnahmen (32) durch sekundäre Austauschflächen (9) aufrechterhalten werden.

16. Vorrichtung nach einem der Ansprüche 14 oder 15, wobei die Aufnahmen (32) derart angeordnet sind, dass die Kanäle (7, 8) zur Zirkulation des Gases der verschiedenen Module (34) parallel zueinander sind.

17. Vorrichtung nach einem der Ansprüche 14 bis 16, wobei der Körper (30) mit einer stoßfesten Außenhülle (38) überzogen ist.

18. Vorrichtung nach einem der Ansprüche 13 bis 17, umfassend einen Kanal (36) zur Zirkulation von Gas, der die Module (34) umgeht.

## Claims

1. Thermoelectric module comprising at least one thermoelectric element (3, 3p, 3n) capable of generating an electrical current under the action of a temperature gradient exerted between two of its faces, one (4a), so-called first, of said faces being of a greater surface area than the other (4b), so-called second, said module being configured to establish a heat exchange between said first face (4a) and a first fluid and to establish a heat exchange between said second face (4b) and a second fluid, said second fluid having a higher heat exchange coefficient than said first fluid, said module being **characterised in that** it comprises a plurality of so-called thermoelectric elements (3, 3p, 3n), and **in that** it also comprises a cold liquid circulation channel (7) in contact with said second surface (4b) of said thermoelectric elements (3, 3p, 3n) and a gas circulation channel (8) in contact with said first surface (4a) of said thermoelectric elements (3, 3p, 3n), the gas circulation channel (8) being provided with secondary exchange surfaces (9), said module comprising an external insulating casing (11) defining an external wall of the gas circulation channel (8).

2. Module according to claim 1, wherein the thermoelectric element (3, 3p, 3n) is in the form of a ring or a portion of a ring, the first surface (4a) is defined by an external peripheral surface of the ring, the second surface (4b) is defined by an internal peripheral surface of the ring.

3. Module according to any one of the preceding claims, wherein said first and/or second surfaces (4a, 4b) are of cylindrical shape.

4. Module according to claim 3, wherein the first surface (4a) has a radius of between 1.5 and 4 times the radius of the second surface (4b).

5. Module according to any one of the preceding claims, wherein said thermoelectric element (3, 3p, 3n) has two opposite parallel planar faces (6a, 6b).

6. Module according to any one of the preceding claims, comprising a plurality of tubes (12) each positioned in the axial extension of the other, in such a way as to define said cold fluid circulation channel (7) and/or a plurality of tubes (13) positioned in the axial extension of the other so as to be able to define successive portions of an internal wall of said gas circulation channel (8).

7. Module according to claim 6, wherein sealing joints (14, 15) are provided between said successive cold liquid circulation tubes (12) and/or between said successive gas circulation tubes (13), ensuring electrical insulation, respectively, between said cold liquid circulation tubes (12) and/or between said gas circulation tubes (13).

8. Module according to claim 7, wherein the cold liquid circulation tubes and/or gas circulation tubes (12, 13) are provided with shoulders (16, 17) against which the thermoelectric elements and/or the sealing joints (14, 15) come to bear.

9. Module according to any one of the preceding claims, comprising a cold liquid circulation tube (12) on which are mounted at least two thermoelectric elements (3, 3p, 3n) of the same type alternating according to the direction of longitudinal extension with a thermoelectric element of the other type.

10. Module according to claim 8, wherein the thermoelectric elements (3, 3p, 3n) are coated with a layer of electrically insulating and thermally conductive material at least partially defining an internal wall of the gas circulation channel (8).

11. Module according to any one of claims 9 or 10, comprising a secondary exchange surface (9), provided in the gas circulation channel (8) and configured to ensure the retention of the thermoelectric elements (3, 3p, 3n).

12. Module according to any one of the preceding claims, comprising a plurality of cold liquid circulation channels (12), parallel to one another, each channel (12) co-operating with a plurality of thermoelectric elements (3, 3p, 3n) each forming an angular cylinder section and each positioned in the extension of the other according to the longitudinal direction of extension of the corresponding channel (12).

13. Thermoelectric device, comprising a plurality of modules according to one of the preceding claims.

14. Device according to claim 13, comprising a body (30) having a plurality of recesses (32) housing said modules (34).

15. Device according to claim 14, where said modules (34) are retained in said recesses (32) by secondary exchange surfaces (9).

16. Device according to any one of claims 14 or 15, wherein said recesses (32) are arranged such that the gas circulation channels (7, 8) of the different modules (34) are parallel to one another.

17. Device according to any one of claims 14 to 16, wherein said body (30) is covered with an external anti-shock casing (38).

18. Device according to any one of claims 13 to 17, comprising a gas circulation channel (36) bypassing said modules (34).
